# EUROPEAN PATENT SPECIFICATION

(11) **EP 1 993 330 B1**
(45) Date of publication and mention of the grant of the patent: **16.02.2011**
(21) Application number: 08155096.4
(22) Date of filing: 24.04.2008
(51) Int. Cl.: H05H 1/24

(54) **Electrode and related apparatus for generating plasma at atmospheric pressure**
Elektrode und Vorrichtung zur Erzeugung eines Atmosphärendruck-Plasmas
Electrode et dispositif associé pour la génération de plasma à pression atmosphérique

(30) Priority: 26.04.2007 IT BO20070306
(43) Date of publication of application: 19.11.2008
(73) Proprietor: Next Technology Tecnotessile Societa' Nazionale di Ricerca R.L., 59100 Prato (PO) (IT)
(72) Inventor: Nesti, Solitario, 51030, SAN BARONTO LAMPORECCHIO (PISTOIA) (IT); Corsi, Leopoldo, 56038, PONSACCO (PISA) (IT); Poggiali, Maurizio, 59100, PRATO (IT); Barbieri, Marco, 59100, PRATO (IT)
(74) Representative: Lanzoni, Luciano

(56) References cited:
- WO-A-00/45623
- WO-A-02/23960
- WO-A-02/103087
- WO-A-2007/032420
- US-A1- 2005 238 817

## Description

The present invention relates to an electrode and related apparatus for generating plasma at atmospheric pressure.

As is known, the term "plasma" refers to a partially ionised gas consisting of ions, electrons and neutral species.

This state of the material may be induced by high temperatures, strong constant electric fields or radio frequency (RF) electromagnetic fields.

"Hot" or high temperature plasmas consist of luminous celestial bodies, nuclear explosions and electric arcs.

"Glow discharge" plasmas are produced by free electrons which, energised by the direct current (DC) applied or by the radio frequency electric fields, collide with the neutral molecules. These impacts between electrons and neutral molecules transfer energy to the molecules and form a type of active species which may include photons, metastable species, atoms, free radicals, molecular fragments, monomers, electrons and ions. These species are chemically and/or physically active and modify the surface of the materials, laying the foundations for the production of new surface properties.

Very low power plasmas, known as corona discharge, have been widely used in the treatment of surfaces of heat-sensitive materials such as paper, wool and synthetic polymers such as polyethylene, polypropylene, nylon and polyester. Due to their low energy content, corona discharge plasmas can alter the properties of a surface of the material without damaging the surface.

"Glow discharge" plasmas are another type of relatively low powered plasma, useful for changing the surface of a material in a non-destructive way. These plasmas may produce significant amounts of visible and ultraviolet radiation. "Glow discharge" plasmas therefore have the added advantage of producing visible and UV radiation, present simultaneously with the active species. However, until now "glow discharge" plasmas have been successfully generated in environments in which a partial vacuum was created, below 10 torr, necessitating the use of expensive vacuum systems.

A examples of electrodes for glow discharging plasmas working at atmospheric pressure are known from documents WO 00/45623 and WO 02/23960.

In contrast, low power plasmas have been generated at atmospheric pressure by means of filament discharges between parallel plates in air, at a pressure of one atmosphere.

This technique is known in particular for generating the ozone used for treating water supplies and is distinguished from the glow discharge plasma technique in terms of uniformity to such an extent that it tends to perforate the surface treated or treat it in an irregular fashion.

There are also prior art solutions for producing metal electrodes incorporated in porous ceramic tubes in which the gas flows, and metal electrodes coated with non-porous silicone material into which, to produce the plasma, the gas is inserted from the outside of the electrode. However, both solutions have limitations: relating to strength in the former case (the ceramic electrode may break), and difficulty producing a homogeneous plasma in the latter case with excessive process gas consumption.

In this context, the main technical purpose of the present invention is to propose an electrode and the relative apparatus for generating a plasma at atmospheric pressure which are free of the disadvantages of the prior art.

In particular, the present invention has for an aim to propose an electrode which has stable dimensions and is strong, able to produce and sustain a plasma with homogeneous density at atmospheric pressure, with reduced gas consumption.

The present invention also has for an aim to provide an apparatus for producing plasma at atmospheric pressure, based on coupling of the electrode with a conductive counter-electrode, one of which must be coated with an organic or inorganic dielectric material.

Another aim of the invention is the possibility of carrying out plasma treatments at atmospheric pressure, without discharges that may damage the material treated and with reduced consumption of the gas, for example helium.

Accordingly, the invention provides an electrode and an apparatus as described in at least one of the claims herein.

The advantages of the invention relate to:
- formation of a uniform plasma;
- production of geometric shapes for the electrodes which are able to avoid discharges typical of corona treatment, in particular on the edges of the electrodes and in the gas inflow and plasma treatment zone;
- application of the plasma using a porous conductive material (applicators), of the known type with sponges made of aluminium or other metals or alloys, or using more complex systems which allow improvements, in the application of the plasma, or in the reduction of gas consumption;
- configuration of the plasma applicators in such a way that the gas is blown onto the surface and penetrates the material so that the plasma treatment is spread over the whole surface. Said effect is particularly important in the treatment of fabrics;
- applicators consisting of a support, preferably metal, housing a porous material through which the gas or mixture of gases is made to flow in order to carry out the process. The porous material is powered by known radio frequency or direct current systems, continuously or in pulses;
- gas diffuser made with an insert of spongy/porous conductive material and/or from an outer shell consisting of one or more layers of a tightly-woven metal mesh;
- gas diffuser also made with an inner membrane of porous ceramic or polymeric material and with a metal mesh outer shell;
- possibility of generating plasma without water-cooling the electrodes.

Further characteristics and advantages of the present invention are more apparent in the description below, with reference to a preferred, non-limiting, embodiment of an electrode and an apparatus for producing plasma at atmospheric pressure, illustrated in the accompanying drawings, in which:
- Figure 1 is a cross-section of the electrode;
- Figure 2 is a perspective view of the longitudinal section of the electrode of Figure 1;
- Figure 3 illustrates a possible system for adjusting the distance from the material using screws;
- Figures 3a, 3b and 3c schematically illustrate examples of an apparatus for generating plasma at atmospheric pressure, applying the device of Figure 1, with the system for adjusting the distance of Figure 3, respectively with a counter-electrode that is cylindrical, or flat and with a counter-electrode obtained using individual electrodes;
- Figure 4 illustrates a second possible system for adjusting the distance of each electrode using cams;
- Figure 4a shows the arrangement of two cams of the type shown in Figure 4 for an electrode;
- Figure 5 illustrates another possible system for adjusting the distance of each electrode using cams with slots, mounted on a sector;

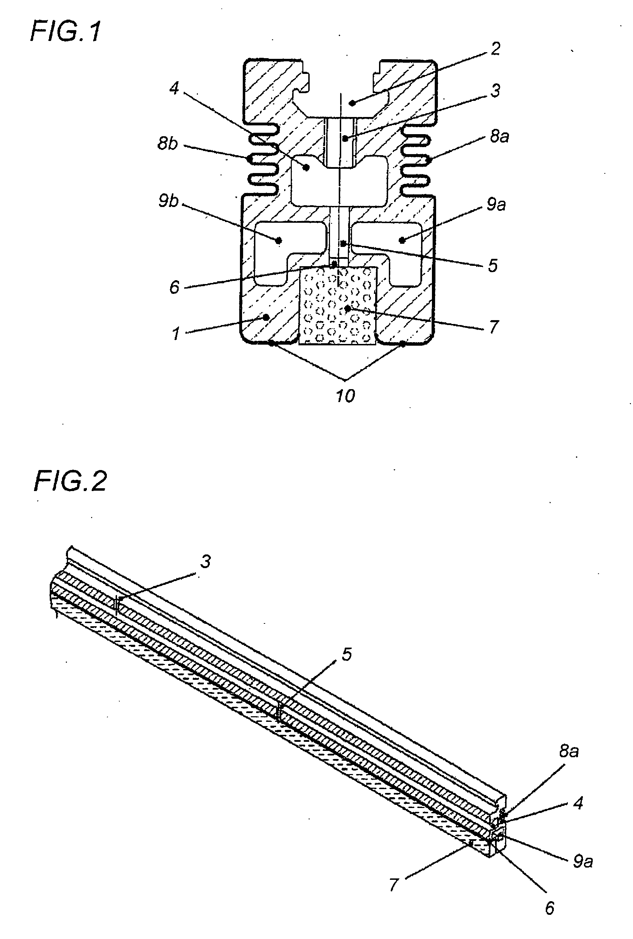

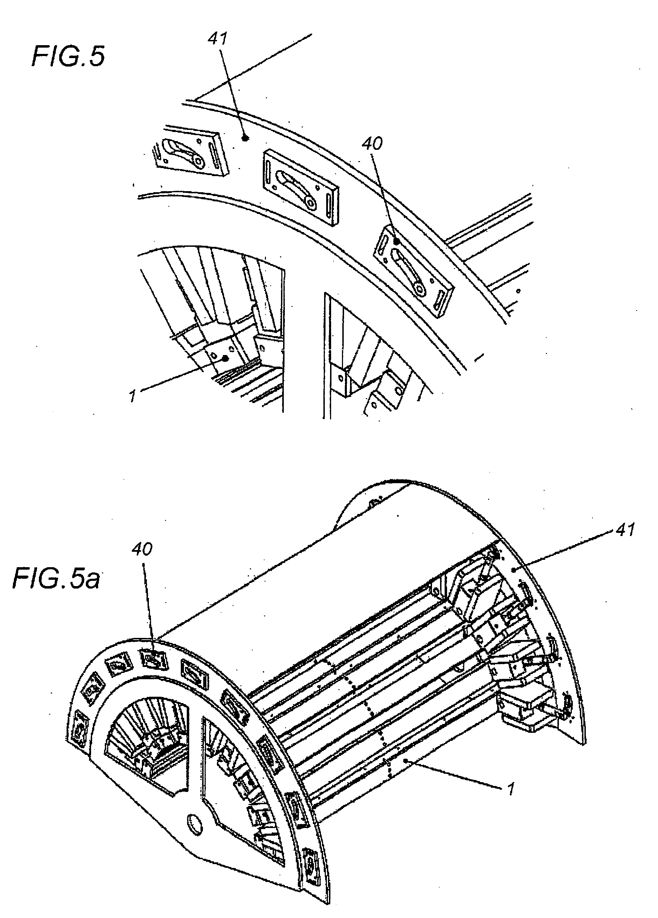

- Figure 5a shows the arrangement of cams of the type shown in Figure 5 for a set of electrodes. With reference to the accompanying drawings, the device shown in Figures 1 and 2 comprises a metal body 1, an outer coating of dielectric material 10, an opening 2 for securely mounting other parts, a set of holes 3 for introduction of the gas, a gas expansion chamber 4, another set of holes 5 for the passage of the gas, another expansion chamber 6, a porous diffuser diaphragm 7 which conducts the gas, a set of outer cooling fins 8a and 8b, and two containment chambers 9a and 9b, for a fluid, if present, which flows in said chambers for the purposes of heat exchange.

The apparatus for generating plasma also comprises a counter-electrode structure 42 and a module for powering the electrodes in radio frequency, of the known type and therefore not illustrated.

The gas for generating the plasma is blown into the device shown in Figure 1, consisting of the metal body 1. The gas flows through a set of holes 3 in the metal body 1 to reach an expansion chamber 4. The gas then flows through a set of holes 5 in the metal body, expands again in an expansion and distribution chamber 6 and flows out through the porous conductive structure 7 which diffuses the gas.

Advantageously, with this solution, the conductive diffuser diaphragm 7 remains inside the electrode 1 and the gas injected into the electrode under pressure can be diffused and expand in the diffuser diaphragm 7 until it reaches atmospheric pressure, forming a glow discharge type plasma which is uniform in the treatment region 43 between the active face of the electrodes 1 and the counter-electrode or counter-electrodes 42.

In this way the material to be treated is exposed to the plasma generated between the electrode and the counter-electrode, one of which is covered by a dielectric layer.

The heat produced by the device, due to the plasma process, is dissipated to the outside by the fins 8a and 8b, and to the inside by heat exchange with the coolant circulating along the cavities 9a and 9b. The cooling system must allow the temperature of the electrode to be kept below 100°C, (preferably below 50°C) to avoid damaging the fabrics or materials to be treated.

The geometry of the outer surface of the electrode 1 is shaped with radiused edges to avoid creating discharges at the edges, which could damage the material to be treated. The radiuses at the edges vary between 2 and 6 mm. Surface treatment using dielectric products 10 allows the production of plasma only on the surface of the porous diaphragm and not on the outer surface of the electrode 1.

The density (or vacuum degree) of the gas diffusing conductive diaphragm 7, if it consists of a metal sponge, varies between 1 g/cc and 100 g/cc. Said density is selected according to the material to be treated, the specifications of the product to be produced (weight/m2, structure of the material, purpose of the treatment) and the process specifications (treatment speed, gas to be used, etc.).

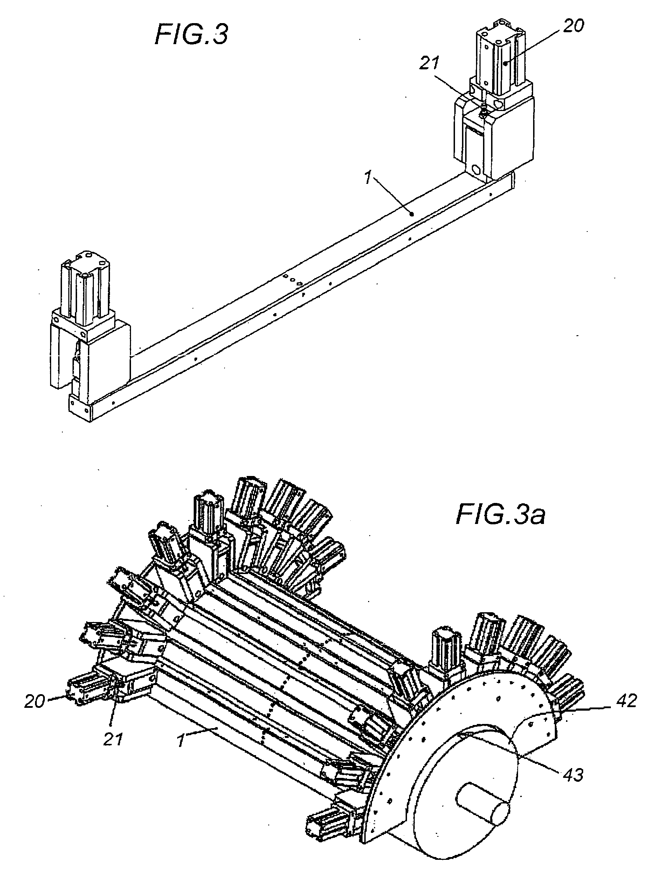

The electrodes 1 may be mounted in the arrangement illustrated in Figure 3a or upside-down, with the electrodes below the cylinder. Said configuration has the advantage of reducing gas consumption (lighter than air). Or they may be mounted in a mixed configuration to simultaneously treat the two faces of the material being processed.

The electrodes 1 are adjusted to a predetermined and specific distance from the surface of the material to be treated. Said adjustment may be performed manually each time the thickness of the material changes, or using an automatic system.

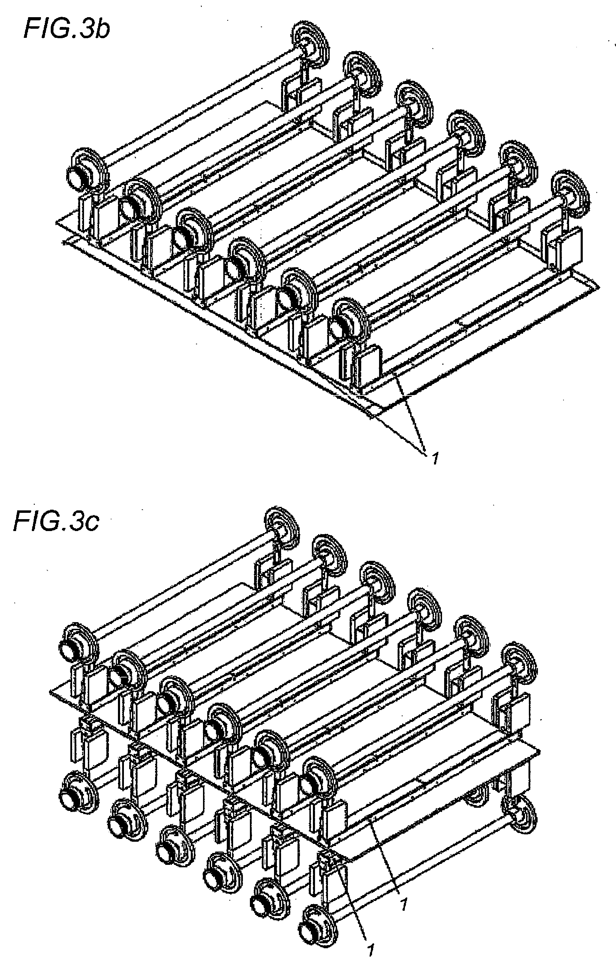

A possible manual/pneumatic mixed system is shown in Figure 3 in which a pneumatic cylinder 20 pushes the electrode towards the counter-electrode 42, whilst the screw 21 adjusts the distance between the two.

Figure 3a shows a possible embodiment with nine electrodes.

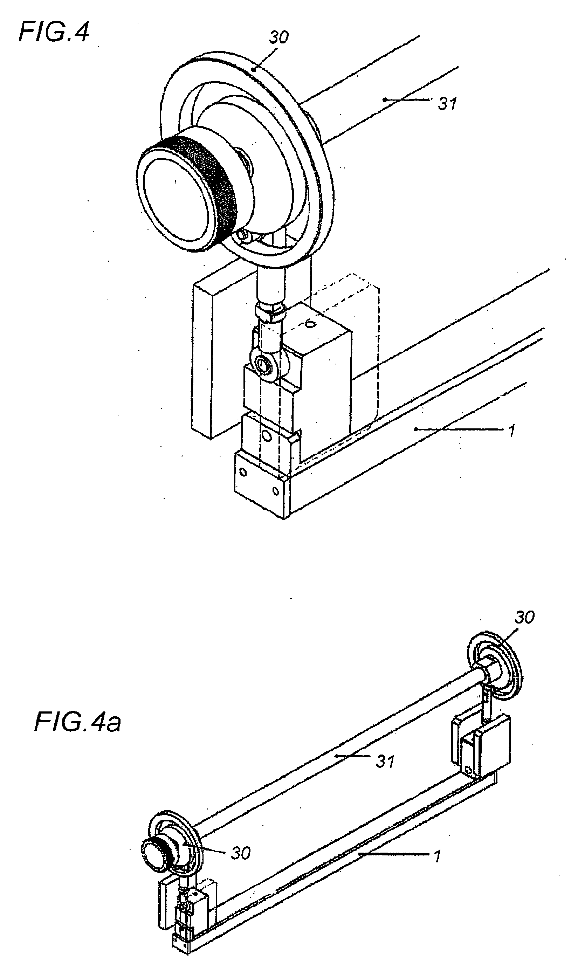

A second mechanical/electric system is shown in Figures 4 and 4a, in which the distance of each electrode is adjusted using cams 30 driven by a shaft 31, which can be operated manually or automatically.

A third system is shown in Figures 5 and 5a, in which individual cams 40 are fixed using slots, which allow adjustment of the distance of the individual electrode, with a sector 41 which can be angled and whose rotation allows the whole set of electrodes to be moved towards or away from the treatment region 43, depending on the thickness of the material being processed.

The invention described above is designed to perform a plasma treatment at atmospheric pressure on the surfaces of textiles consisting of natural, synthetic or artificial fibres, or other polymeric materials (plastic films, paper, leather, etc.), or surfaces in general which are passed over the active face of the electrodes.

## Claims

1. An electrode for generating plasma, comprising a metal main conductive body (1), and a porous diaphragm (7) with electric conduction properties connected to the metal body (1) and presenting an outer active surface for forming the plasma, said porous diaphragm (7) diffusing a gas from an inner region of the body (1) towards an outer region at atmospheric pressure, **characterised in that** it comprises at least one containment chamber (9a, 9b) in the electrode body for containing a coolant for heat exchange towards the inside of the electrode body.

2. The electrode according to claim 1, **characterised in that** at the edges of said active surface there is an inorganic or organic dielectric material (10).

3. The electrode according to claim 2, wherein the dielectric material (10) is obtained by hard anodising the body (1).

4. The electrode according to any of the foregoing claims, wherein the diffuser means comprise a body (1) first expansion chamber (4) communicating through one or more distribution holes (5) with a second, expansion chamber (6), communicating with the porous diaphragm (7).

5. The electrode according to any of the foregoing claims, **characterised in that** the coolant is an organic material which is pure or in the glycolic phase.

6. The electrode according to any of the foregoing claims, **characterised in that** the coolant is a gas.

7. The electrode according to any of the foregoing claims, **characterised in that** it comprises means for making the coolant circulate in the chambers (9a and 9b).

8. An apparatus for plasma treatments, comprising at least one electrode according to one or more of the claims from 1 to 7, and at least one counter-electrode (42) positioned opposite the electrode and together with the latter forming a treatment region (43) for generating the plasma.

9. The apparatus according to claim 8, **characterised in that** it comprises adjusting means for adjusting the distance of at least one electrode and/or a counter-electrode from the treatment region.

10. The apparatus according to claim 9, wherein the adjusting means operate to adjust the distance individually for each electrode and/or overall by means of pneumatic-mechanical/electric or manual actuators.

11. The apparatus according to any of the claims from 8 to 10, **characterised in that** at least one counter-electrode is made according to one of the claims from 1 to 6.

## Patentansprüche

1. Elektrode zur Erzeugung von Plasma, beinhaltend einen metallischen leitfähigen Hauptkörper (1) und eine durchlässige Membran (7) mit elektrischen Leitfähigkeitseigenschaften, die mit dem Metallkörper (1) verbunden ist und eine äußere aktive Oberfläche zur Erzeugung des Plasmas aufweist, wobei die durchlässige Membran (7) ein Gas aus einem inneren Bereich des Körpers (1) bei Atmosphärendruck zu einem äußeren Bereich diffundieren lässt, wobei die Elektrode **dadurch gekennzeichnet ist, dass** sie zumindest eine Aufnahmekammer (9a, 9b) im Elektrodenkörper zur Aufnahme eines Kühlmittels für den Wärmetausch zum Innern des Elektrodenkörpers hin beinhaltet.

2. Elektrode nach Anspruch 1, **dadurch gekennzeichnet, dass** die Ränder der genannten aktiven Oberfläche ein anorganisches oder organisches dielektrisches Material (10) aufweisen.

3. Elektrode nach Anspruch 2, worin das dielektrische Material (10) durch Harteloxieren des Körpers (1) erhalten wird.

4. Elektrode nach einem der vorhergehenden Ansprüche, worin die Diffusionsmittel eine erste Expansionskammer (4) des Körpers (1) beinhalten, die über eine oder mehrere Verteilungsöffnungen (5) mit einer zweiten Expansionskammer (6) verbunden ist, welche mit der durchlässigen Membran (7) in Verbindung steht.

5. Elektrode nach einem der vorhergehenden Ansprüche, **dadurch gekennzeichnet, dass** das Kühlmittel ein organisches Material in reiner Form oder in glykolischer Phase ist.

6. Elektrode nach einem der vorhergehenden Ansprüche, **dadurch gekennzeichnet, dass** das Kühlmittel ein Gas ist.

7. Elektrode nach einem der vorhergehenden Ansprüche, **dadurch gekennzeichnet, dass** es Mittel beinhaltet, die das Zirkulieren des Kühlmittels in den Kammern (9a und 9b) bewirken.

8. Vorrichtung für Plasmabehandlungen, beinhaltend zumindest eine Elektrode nach einem oder mehreren der Ansprüche von 1 bis 7 und zumindest eine Gegenelektrode (42), die gegenüber der Elektrode angeordnet ist und zusammen mit der letztgenannten einen Behandlungsbereich (43) für die Erzeugung des Plasmas bildet.

9. Vorrichtung nach Anspruch 8, **dadurch gekennzeichnet, dass** sie Einstellungsmittel zum Regulieren des Abstandes zumindest einer Elektrode und/oder einer Gegenelektrode von dem Behandlungsbereich beinhaltet.

10. Vorrichtung nach Anspruch 9, worin die Einstellungsmittel so wirken, dass der Abstand einzeln für jede Elektrode und/oder im Gesamten über pneumatisch-mechanische/elektrische oder manuelle Stellantriebe reguliert wird.

11. Vorrichtung nach einem der Ansprüche von 8 bis 10, **dadurch gekennzeichnet, dass** zumindest eine Gegenelektrode nach einem der Ansprüche von 1 bis 6 hergestellt ist.

## Revendications

1. Une électrode pour la génération de plasma, comprenant un corps métallique conducteur principal (1), et une membrane poreuse (7) ayant des propriétés de conduction électrique, associée audit corps métallique (1) et présentant une surface active extérieure pour la formation du plasma, ladite membrane poreuse (7) diffusant un gaz d'une région intérieure du corps (1) vers une région extérieure à pression atmosphérique, ladite électrode étant **caractérisée en ce qu'**elle comprend au moins une chambre-contenant (9a, 9b) réalisée dans le corps d'électrode et destinée à contenir un liquide de refroidissement pour un échange de chaleur vers l'intérieur dudit corps d'électrode.

2. L'électrode selon la revendication 1, **caractérisée en ce qu'**au niveau des bords de ladite surface active, il y a un matériau diélectrique (10) inorganique ou organique.

3. L'électrode selon la revendication 2, **caractérisée en ce que** le matériau diélectrique (10) est obtenu par anodisation dure du corps (1).

4. L'électrode selon l'une quelconque des revendications précédentes, **caractérisée en ce que** les moyens de diffusion comprennent une première chambre d'expansion (4) du corps (1) communiquant par un ou plusieurs trous de distribution (5) avec une deuxième chambre d'expansion (6) communiquant avec la membrane poreuse (7).

5. L'électrode selon l'une quelconque des revendications précédentes, **caractérisée en ce que** le liquide de refroidissement est un matériau organique qui est pur ou en phase glycolique.

6. L'électrode selon l'une quelconque des revendications précédentes, **caractérisée en ce que** le liquide de refroidissement est un gaz.

7. L'électrode selon l'une quelconque des revendications précédentes, **caractérisée en ce qu'**elle comprend des moyens pour faire circuler le liquide de refroidissement dans les chambres (9a et 9b).

8. Un dispositif pour traitements au plasma, comprenant au moins une électrode selon une ou plusieurs des revendications de 1 à 7, et au moins une contre-électrode (42) positionnée à l'opposé de l'électrode et formant avec cette dernière une région de traitement (43) pour la génération du plasma.

9. Le dispositif selon la revendication 8, **caractérisé en ce qu'**il comprend des moyens de réglage servant à régler la distance au moins d'une électrode et/ou d'une contre-électrode par rapport à la région de traitement.

10. Le dispositif selon la revendication 9, **caractérisé en ce que** les moyens de réglage agissent pour régler la distance séparément pour chaque électrode et/ou globalement par l'intermédiaire d'actionneurs pneumo-mécaniques/électriques ou manuels.

11. Le dispositif selon l'une quelconque des revendications de 8 à 10, **caractérisé en ce qu'**au moins une contre-électrode est réalisée selon une des revendications de 1 à 6.
